# EUROPEAN PATENT APPLICATION

(11) **EP 2 634 795 A1**
(43) Date of publication of application: **04.09.2013**
(21) Application number: 11836333.2
(22) Date of filing: 26.10.2011
(51) Int. Cl.: H01L 21/768, H01L 23/52, H01L 21/3205

(54) **PROCESS FOR MANUFACTURE OF THROUGH-TYPE WIRING SUBSTRATE, AND THROUGH-TYPE WIRING SUBSTRATE**

(30) Priority: 29.10.2010 JP 2010243873
(71) Applicant: Fujikura Co., Ltd., Tokyo 135-8512 (JP)
(72) Inventor: ONAI Satoshi, Sakura-shi Chiba 285-8550 (JP)
(74) Representative: Cabinet Plasseraud
(86) International application number: PCT/JP2011/074664
(87) International publication number: WO 2012/057200

(57) **Abstract**

A method for manufacturing an interposer substrate includes: forming a conductive portion on a first surface of a semiconductor substrate via a first insulating layer, the conductive portion being formed of a first metal; forming a through hole at a second surface side of the semiconductor substrate located on an opposite side to the first surface so as to expose the first insulating layer; forming a second insulating layer on at least an inner wall surface and a bottom surface of the through hole; exposing the conductive portion by removing portions of the first and second insulating layers using a dry etching method that uses an etching gas containing a fluorine gas, the portions of the first and second insulating layers being located on the bottom surface of the through hole; and forming a conductive layer on the second insulating layer and electrically connecting the conductive layer to the conductive portion, wherein when exposing the conductive portion, forming a tapered portion is performed by etching a part of the conductive portion subsequent to the second insulating layer and depositing a first by-product formed of the first metal component removed by etching and the etching gas component on a bottom surface portion of the through hole and an inner wall surface portion, the inner wall surface portion being located near the bottom surface portion.

## Description

### TECHNICAL FIELD

The present invention relates to an interposer substrate manufacturing method and an interposer substrate.
Priority is claimed on Japanese Patent Application No. 2010-243873, filed October 29, 2010, the content of which is incorporated herein by reference.

### BACKGROUND ART

In recent years, electronic apparatuses, such as mobile phones, have higher functionality, development to achieve miniaturization and higher performance of optical devices themselves including electronic devices, such as ICs or LSIs, and optical devices, such as OEICs or optical pickups, is being made in various places.
For example, a technique for providing these devices by stacking has been proposed.
Specifically, there is an interposer substrate including a through-hole interconnections that passes through one surface of the substrate, on which a certain functional unit is provided, from the other surface thereof and that is connected to an electrode formed on the one surface.

When forming a wiring in such an interposer substrate, it is important in terms of wiring quality to improve the step coverage of a barrier layer/seed layer in a through hole.
In particular, when a through hole is formed vertically and an insulating material is also formed similarly vertically for the hole shape, there is a problem in that defects, such as poor electrical conduction or wire breakage, are easily caused since a conductive material is thin in the vicinity of the bottom surface portion when forming a conductive layer on the seed layer.

There are two ways described below in order to improve the step coverage of the barrier layer/seed layer.
(1) Adoption of a long throw sputtering method or collimation sputtering method, or improvement of a barrier/seed layer forming method using an organic metal CVD method or the like.
(2) Improvement of conditions for forming a through hole.

However, in particular, since the absolute value of the depth of the through hole is as large as approximately 100 to 200 µm in the interposer substrate having top and bottom surfaces electrically connected to each other, which is represented by TSV (Through Silicon via), it is required to form a barrier layer/seed layer in a through hole having a large aspect ratio.
For this reason, it is difficult to improve the step coverage just by changing the sputtering conditions or the like, that is, with only the method described in (1).

On the other hand, as examples of the improvement method described in (2), a technique of executing tapering by repeating the etching of a sacrificial layer multiple times (For example, see Patent Document 1 below) or a technique of tapering the shape of a through hole using the etching rate difference between materials after performing flattening using an auxiliary material (for example, see Patent Document 2) has been proposed.

However, if the sacrificial layer etching is applied multiple times, there is a problem in that cost increases since the number of film deposition times and the number of etching times increase.
In addition, the shape improvement method using an auxiliary material is a streamlined process since only one step of material coating is increased.
However, since it is difficult to reduce the large step difference, it is difficult to apply it to the TSV

### PRIOR ART DOCUMENTS

### PATENT DOCUMENTS

[Patent Document 1] Japanese Patent (Granted) Publication No. 2616380
[Patent Document 2] Japanese Unexamined Patent Application, First Publication No. H11-274299

### DISCLOSURE OF INVENTION

### PROBLEMS TO BE SOLVED BY INVENTION

The present invention has been devised in view of such a conventional situation, and it is a first object of the present invention to provide an interposer substrate manufacturing method capable of forming a conductive layer in the vicinity of a bottom surface portion of a through hole with good coverage and accordingly forming a through-hole interconnections, which has improved electrical stability without poor contacts and the like, without increasing the number of steps or cost.
In addition, it is a second object of the present invention to provide an interposer substrate having improved electrical stability of a through-hole interconnections since there are no poor contacts and the like in the vicinity of the bottom surface portion of the through-hole interconnections.

### MEANS FOR SOLVING THE PROBLEMS

A method for manufacturing an interposer substrate according to an aspect of the present invention is a method for manufacturing an interposer substrate including the steps of: forming a conductive portion on a first surface of a semiconductor substrate via a first insulating layer, the conductive portion being formed of a first metal (first step); forming a through hole at a second surface side of the semiconductor substrate located on an opposite side to the first surface so as to expose the first insulating layer (second step); forming a second insulating layer on at least an inner wall surface and a bottom surface of the through hole (third step); exposing the conductive portion by removing portions of the first and second insulating layers using a dry etching method that uses an etching gas containing a fluorine gas, the portions of the first and second insulating layers being located on the bottom surface of the through hole (fourth step); and forming a conductive layer on the second insulating layer and electrically connecting the conductive layer to the conductive portion (fifth step). When exposing the conductive portion (in the fourth step), forming a tapered portion is performed by etching a part of the conductive portion subsequent to the second insulating layer and depositing a first by-product formed of the first metal component removed by etching and the etching gas component on a bottom surface portion of the through hole and an inner wall surface portion, the inner wall surface portion being located near the bottom surface portion
When forming the conductive portion (in the first step), forming a barrier metal film formed of a second metal between the first insulating layer and the conductive portion may be performed. When exposing the conductive portion (in the fourth step), forming a tapered portion may be performed by removing portions of the first and second insulating layers and the barrier metal film, the portions being located on the bottom surface of the through hole, etching a part of the conductive portion subsequent to the barrier metal film, and depositing a second by-product formed of the second metal component removed by etching and the etching gas component and the first by-product formed of the first metal component removed by etching and the etching gas component on the bottom surface portion of the through hole and the inner wall surface portion, the inner wall surface portion being located near the bottom surface portion.
Before electrically connecting the conductive layer to the conductive portion after exposing the conductive portion (between the fourth and fifth steps), a metal film may be formed so as to cover at least the by-product (sixth step).
An interposer substrate according to another aspect of the present invention is an interposer substrate including: a conductive portion formed of a first metal and disposed on a first surface of a semiconductor substrate via a first insulating layer; a through hole disposed at a second surface side of the semiconductor substrate so as to expose the conductive portion, the second surface side being located on an opposite side to the first surface; a second insulating layer disposed on at least an inner wall surface of the through hole; and a conductive layer disposed on the second insulating layer and electrically connected to the conductive portion. A tapered portion is formed over a bottom surface portion and an inner wall surface portion, the inner wall surface portion being located near the bottom surface portion, of the through hole, and the tapered portion includes the first metal component.
A barrier metal film formed of a second metal may be disposed between the first insulating layer and the conductive portion, and the tapered portion formed in the vicinity of the bottom surface portion of the through hole may include the first and second metal components.
The amount of the second metal component may be larger than the amount of the first metal component in a portion of the tapered portion close to a side wall of the through hole, and the amount of the first metal component may be larger than the amount of the second metal component in a portion of the tapered portion away from the side wall of the through hole.

### EFFECTS OF THE INVENTION

In the method for manufacturing an interposer substrate according to an aspect of the present invention, when exposing the conductive portion by removing the portions of the first and second insulating layers located on the bottom surface of the through hole (fourth step), a part of the conductive portion is etched subsequent to the second insulating layer and the first by-product formed of the first metal component removed by etching and the etching gas component is deposited on the bottom surface portion and the inner wall surface portion, which is located in a region close to the bottom surface portion, of the through hole, thereby forming the tapered portion.
For this reason, in next step, when forming the conductive layer on the second insulating layer and electrically connecting the conductive layer to the conductive portion subsequently (fifth step), the bottom surface portion of the through hole is tapered. Accordingly, the conductive layer having a predetermined thickness can be stably formed with good coverage.
In addition, according to the method for manufacturing an interposer substrate according to an aspect of the present invention, it is possible to eliminate a step of peeling off the by-product deposited on the bottom portion of the through hole and also to form the tapered portion at the hole bottom without an additional step. As a result, it is possible to suppress an increase in cost.
In the present invention, therefore, it is possible to provide an interposer substrate manufacturing method capable of forming a through-hole interconnections, which has improved electrical stability without poor contacts and the like, in the vicinity of the bottom surface portion of the through hole without increasing the number of steps or cost.

In addition, in the interposer substrate according to another aspect of the present invention, the tapered portion is formed over the bottom surface portion and the inner wall surface portion, which is located near the bottom surface portion, of the through hole, and the tapered portion includes the first metal component.
In the present invention, since the bottom surface portion of the through hole is tapered, the conductive layer disposed on the bottom surface portion has a predetermined thickness. Accordingly, there is no possibility that an uneven place in thickness may be locally caused.
Therefore, according to the present invention, it is possible to provide an interposer substrate having improved electrical stability of the through-hole interconnections since there are no poor contacts and the like in the vicinity of the bottom surface portion of the through-hole interconnections.

### BRIEF DESCRIPTION OF DRAWINGS

FIG. 1A is a cross-sectional view schematically showing a first step of an interposer substrate manufacturing method according to an embodiment of the present invention.
FIG. 1B is a cross-sectional view schematically showing a second step of the manufacturing method.
FIG. 2A is a cross-sectional view schematically showing a third step of the manufacturing method.
FIG. 2B is an enlarged view of main parts shown in FIG. 2A.
FIG. 2C is a cross-sectional view schematically showing a fourth step of the manufacturing method.
FIG. 3A is an enlarged view of main parts shown in FIG. 2C.
FIG. 3B is a cross-sectional view schematically showing a sixth step of the manufacturing method.
FIG. 3C is an enlarged view of main parts shown in FIG. 3B.
FIG. 4A is a cross-sectional view schematically showing a fifth step of the same manufacturing method.
FIG. 4B is a cross-sectional view schematically showing a seventh step of the manufacturing method.
FIG. 5 is an SEM photograph of the cross section of the interposer substrate manufactured by the method according to the present embodiment.
FIG. 6 is a cross-sectional view schematically showing an example of the configuration of the interposer substrate according to the present embodiment.

### EMBODIMENTS FOR CARRYING OUT THE INVENTION

Hereinafter, an interposer substrate manufacturing method and an interposer substrate according to an embodiment of the present invention will be described referring to the drawings.

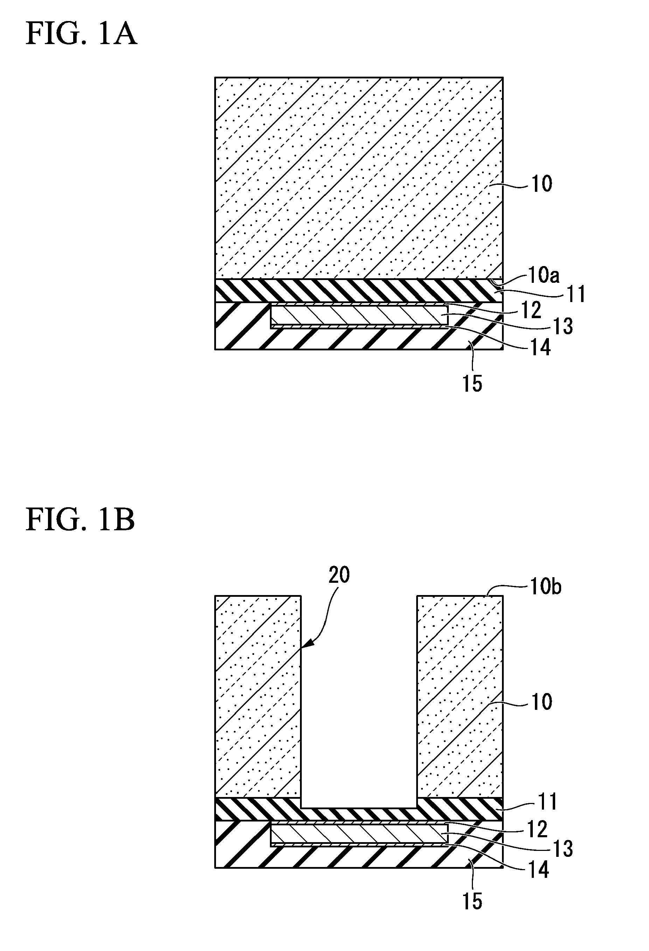

FIGS. 1A to 4B are cross-sectional views schematically showing the interposer substrate manufacturing method according to the present embodiment.
The interposer substrate manufacturing method according to the present embodiment is a method for manufacturing an interposer substrate 1 including: a first step of forming a conductive portion (for example, an electrode, a wiring, and the like) 13, which is formed of a first metal, on one surface (first surface) 10a of a semiconductor substrate 10 with a first insulating layer 11 interposed therebetween; a second step of forming a through hole 20 at a other surface (second surface) 10b side of the semiconductor substrate 10 located on an opposite side to the first surface so as to expose the first insulating layer 11; a third step of forming a second insulating layer 21 on at least an inner wall surface and a bottom surface of the through hole 20; a fourth step of exposing the conductive portion 13 by removing portions of the first and second insulating layers 11 and 21, which are located on the bottom surface of the through hole 20, using a dry etching method that uses an etching gas containing a fluorine gas; and a fifth step of forming a conductive layer 25 on the second insulating layer 21 and electrically connecting the conductive layer 25 to the conductive portion 13. In the fourth step, a part of the conductive portion 13 is etched subsequent to the second insulating layer 21 and a first by-product formed of the first metal component removed by etching and the etching gas component is deposited on a bottom surface portion and an inner wall surface (inner side surface) portion, which is located in a region close to the bottom surface portion, of the through hole 20, thereby forming a tapered portion 22.

In the present embodiment, when exposing the conductive portion 13 by removing the portions of the first and second insulating layers 11 and 21 located on the bottom surface of the through hole 20 (fourth step), a part of the conductive portion 13 is etched subsequent to the second insulating layer 21 and the first by-product formed of the first metal component removed by etching and the etching gas component is deposited on the bottom surface portion and the inner wall surface portion, which is located in a region close to the bottom surface portion, of the through hole 20, thereby forming the tapered portion 22.
Then, when forming the conductive layer 25 on the second insulating layer 21 and electrically connecting the conductive layer 25 to the conductive portion 13 (fifth step), the bottom surface portion of the through hole 20 is tapered. Accordingly, the conductive layer 25 having a predetermined thickness can be stably formed with good coverage.
Therefore, in the method for manufacturing the interposer substrate 1 of the present embodiment, it is possible to manufacture the interposer substrate 1 in which there are no poor contacts and the like in the vicinity of the bottom surface portion of the through hole 20 and which has a through-hole interconnections with improved electrical stability.
In addition, according to the method of the present embodiment, it is possible to eliminate a step of peeling off the by-product deposited on the bottom portion of the through hole 20 and also to form the tapered portion at the hole bottom without an additional step. As a result, it is possible to suppress an increase in cost.
Hereinafter, the above will be described in process order.

(1) The conductive portion 13 of the first metal is formed on one surface 10a of the semiconductor substrate 10 with the first insulating layer 11 interposed therebetween (first step).
First, as shown in FIG. 1A, the semiconductor substrate 10 is prepared, and the conductive portion 13 (I/O pad) is formed on one surface 10a (bottom surface in FIG. 1A) with the first insulating layer 11 interposed therebetween.

As an interposer substrate (device) to which the present embodiment can be applied, a device having an active area (for example, a micro lens in an image sensor and a movable conductive portion in an MEMS device) that has a three-dimensional structure on the substrate surface, such as an image sensor or an MEMS device, may be mentioned.
The present embodiment can also be appropriately used for the manufacture using a wafer level package technique.

The semiconductor substrate 10 may be a semiconductor wafer formed of not only Si but also compound semiconductor, such as SiGe or GaAs, or may be a semiconductor chip obtained by cutting (dicing) the semiconductor wafer in a chip size.
When the semiconductor substrate 10 is a semiconductor chip, it is possible to obtain a plurality of semiconductor chips by forming a plurality of sets of various semiconductor elements, ICs, and the like on a semiconductor wafer first and then cutting the semiconductor wafer in a chip size.
As the first insulating layer 11, for example, oxidation silicon (SiO₂) may be used.

As examples of the material of the conductive portion 13, materials excellent in conductivity, such as aluminum (A1) or copper (Cu), aluminum silicon (Al-Si) alloy, and aluminum-silicon-copper (Al-Si-Cu) alloy, may be appropriately used.
In addition, in the present embodiment, Al-Si-Cu is formed as the conductive portion 13 in a thickness of 2.0 µm.

In addition, in the present embodiment, a barrier metal film 12 of second metal is formed between the first insulating layer 11 and the conductive portion 13.
Such a barrier metal film 12 is formed of TiN, TiW, or Cr, for example.
Here, the barrier metal film 12 is formed of TiN.
In addition, an antireflection film 14 is disposed on a surface of the conductive portion 13 opposite the surface on which the barrier metal film 12 is disposed.
The antireflection film 14 is formed of the same material as the barrier metal film 12.
In addition, a third insulating layer 15 formed of oxidation silicon (SiO₂), for example, is disposed on the surface 10a side of the semiconductor substrate 10 so as to cover the conductive portion 13.

(2) The through hole 20 at the other surface side of the semiconductor substrate 10 so as to expose the first insulating layer 11 (second step).
Then, as shown in FIG. 1B, the through hole 20 that passes through the semiconductor substrate 10 from the other surface 10b side to expose the first insulating layer 11 is formed in the semiconductor substrate 10, for example, using a DRIE (Deep Reactive Ion Etching) method.
In addition, 100 to 400 nm of the first insulating layer 11 is etched.
Here, the DRIE method is one of reactive ion etching (RIE) methods.
For example, this is a method of performing deep etching in the semiconductor substrate 10 using a technique (Bosch process), in which high-density plasma etching and passivation film formation on the side wall of the through hole 20 are alternately performed using sulfur hexafluoride (SF₆) as an etching gas, or a technique (Cryo process), in which etching is performed in a state where a semiconductor substrate is cooled to a temperature of -50°C or lower using an etching gas, such as SF₆ gas.

In addition, the shape of a cross section of the through hole 20 perpendicular to the depth direction may be any shape, such as a circle, an ellipse, a triangle, a square, or a rectangle, and its size is also appropriately set according to the desired size, conductivity (resistance value), and the like of the interposer substrate 1.
In addition, the method of forming the through hole 20 is not limited to the DRIE method, it is also possible to use a laser processing method or a wet etching method using a potassium hydroxide (KOH) aqueous solution or the like.

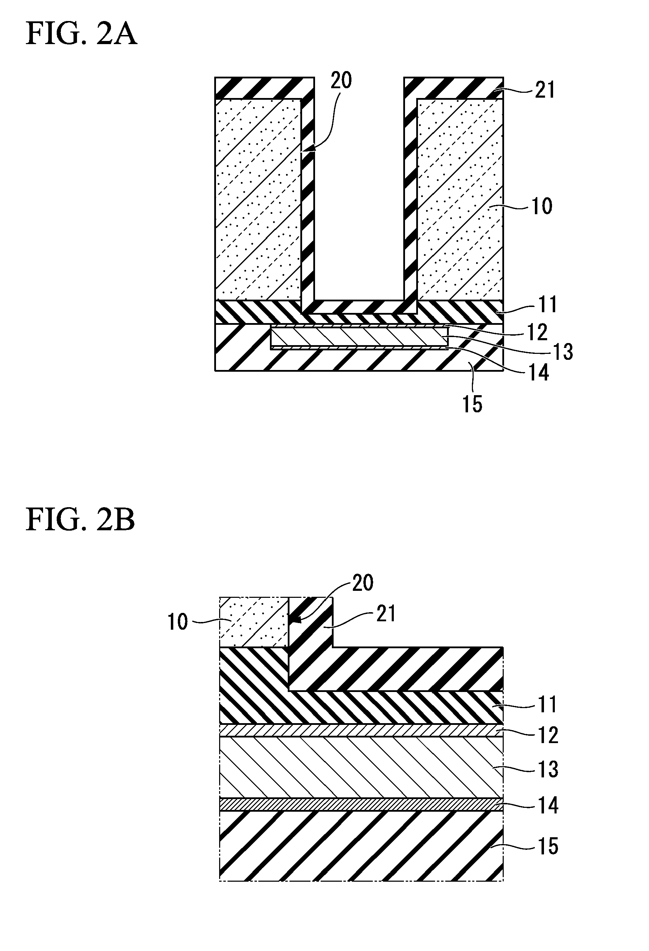

(3) The second insulating layer 21 is formed on at least the inner wall surface and the bottom surface of the through hole 20 (third step).
Then, as shown in FIGS. 2A and 2B, the second insulating layer 21 is formed on at least the inner wall surface and the bottom surface of the through hole 20 (third step).
In addition, FIG. 2B is an enlarged view of main parts shown in FIG. 2A.
Silicon oxide (SiO₂), silicon nitride (Si₃N₄), phosphorus silicate glass (PSG), boron phosphorus silicate glass (BPSG), and the like may used as the second insulating layer 21, and it is preferable to select the material of the second insulating layer 21 appropriately according to the use environment of the semiconductor package.
The insulating layer formed of SiO₂ or Si₃N₄ can be formed in an arbitrary thickness using a CVD method, for example.
For example, the insulating layer of SiO₂ can be formed using a plasma CVD method that uses silane or tetraethoxysilane (TEOS) as a raw material.
The thickness of the second insulating layer 21 can be set to 2.5 µm within the hole, for example.
In addition, in this case, it is preferable to form the second insulating layer 21, which is formed near an opening, thicker than the hole bottom of the through hole 20.
By thickening the thickness of the second insulating layer 21 near the opening, the process in the fourth process to be described later becomes easy.

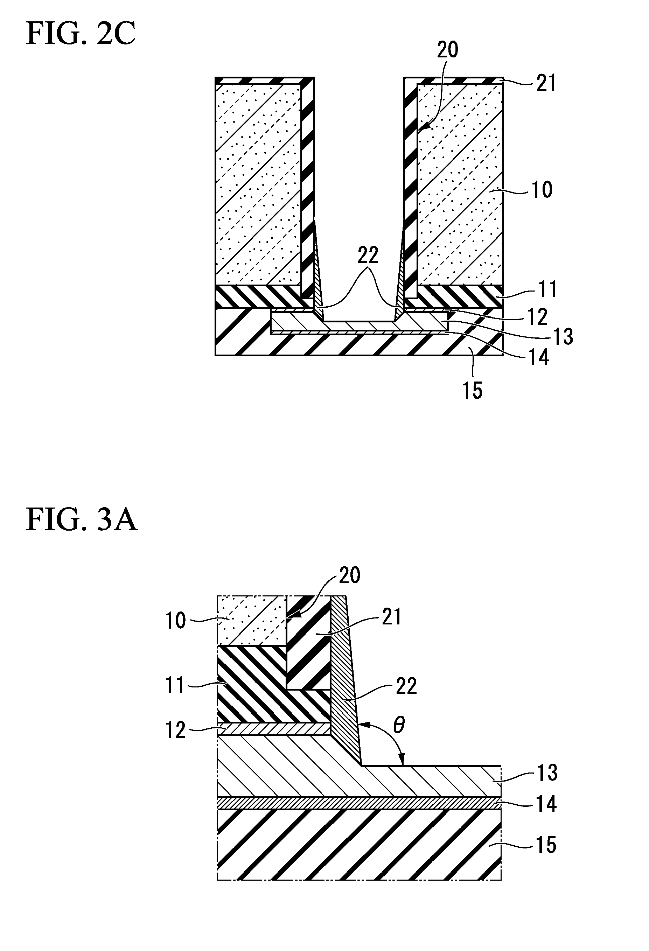

(4) The conductive portion 13 is exposed by removing portions of the first and second insulating layers 11 and 21, which are located on the bottom surface of the through hole 20, using a dry etching method that uses an etching gas containing a fluorine gas (fourth step).
Then, as shown in FIGS. 2C and 3A, the conductive portion 13 on the side of the first substrate 10 is exposed in the through hole 20 by removing portions of the first and second insulating layers 11 and 21, which cover the bottom surface of the through hole 20, using the RIE method.
In addition, FIG. 3A is an enlarged view of main parts shown in FIG. 2C.

In the present embodiment, a process gas (etching gas) containing the fluorine is used.
Specifically, the insulating layers are etched using a dry etching method that uses RIE using a mixed gas of carbon tetrafluoride (CF₄), SF₆, and argon (Ar), for example.
The flow rate of each gas is set to CF₄: 25 cm³/min, SF₆: 10 cm³/min, and Ar: 80 cm³/min, for example.
In addition, power at the time of etching is set to 1000 W, and the process gas pressure is set to 1 Pa, for example.

In this case, in consideration of the etching rate difference between the surface of the semiconductor substrate 10 and the insulating layer of the hole bottom, it is preferable to adjust the etching rate or the film thickness such that only the first and second insulating layers 11 and 21 formed on the hole bottom are completely removed and the second insulating layer 21 formed on the surface of the semiconductor substrate 10 remains.
Specifically, the etching rate or the film thickness is adjusted, for example, such that the etching selectivity of the first and second insulating layers 11 and 21 (SiO₂)/conductive portion 13 (Al-Si-Cu) becomes 1.5 to 3.0.
The conductive portion 13 on the device side is etched back to be exposed, and the etching of the conductive portion 13 continues.
Full etching of the barrier metal film 12 (TiN) is performed, and half etching of the conductive portion 13 is performed.
In this case, it is preferable to etch 300 to 500 nm of the conductive portion 13.

In this case, Ti, which is a component of the barrier metal film 12 removed by etching, and Al, which is a component of the conductive portion 13, react with the fluorine (F) contained in the etching gas. As a result, Ti-F-C (second by-product) and Al-F-C (first by-product) are generated as by-products.
These by-products are deposited on the bottom surface portion and the inner wall surface (inner side surface) portion, which is located near the bottom surface portion, of the through hole 20.

In the dry etching of an oxide film in a general method for forming a through hole in a semiconductor in the related art, the selection ratio of SiO₂/Al is approximately 10 to 20. Accordingly, the Al-F-C film deposited on the side wall is thin, and is physically unstable.
For this reason, the Al-F-C film is peeled off in subsequent steps to become a source of a particle.
In addition, these by-products (Ti-F-C and Al-F-C) contain F that reacts with moisture to generate hydrofluoric acid. Accordingly, in the related art, in order to suppress the generation of hydrofluoric acid, these by-products were removed after the completion of etching.

On the other hand, in the present embodiment, when exposing the conductive portion 13 by removing the portions of the first and second insulating layers 11 and 21 and the barrier metal film 12 (TiN) located on the bottom surface of the through hole 20, a part of the conductive portion 13 (Al-Si-Cu) is etched subsequent to the barrier metal film 12, and the second by-product (Ti-F-C) formed of the second metal component removed by etching and the etching gas component (C and F) and the first by-product (Al-F-C) formed of the first metal component removed by etching and the etching gas component are deposited on the bottom surface portion and the inner wall surface portion, which is located near the bottom surface portion, of the through hole 20, thereby forming the tapered portion 22.

The tapered portion 22 is formed by depositing the first and second by-products generated at the time of etching on the bottom surface portion and the inner wall surface portion, which is located near the bottom surface portion, of the through hole 20.
Then, in the fifth step to be described later, when forming the conductive layer 25 on the second insulating layer 21 and electrically connecting the conductive layer 25 to the conductive portion 13, the bottom surface portion of the through hole 20 is tapered. Accordingly, the conductive layer 25 having a predetermined thickness can be stably formed with good coverage.

Half etching of the barrier metal film 12 and the conductive portion 13 is performed by reducing the selection ratio of the first and second insulating layers 11 and 21 (SiO₂)/barrier metal film 12 (TiN)/conductive portion 13 (Al-Si-Cu) to 1.5 to 3 in oxide film dry etching using CF₄, SF₆, and Ar as etching gas when forming the through hole 20.
When etching the barrier metal film 12 (TiN) and the conductive portion 13 (Al-Si-Cu), Ti-F-C (second by-product) and Al-F-C (first by-product) are generated as by-products and are deposited on the bottom surface portion and the inner wall surface portion, which is located near the bottom surface portion, of the through hole 20.

The deposition of these by-products is focused on the bottom surface portion and the inner wall surface portion, which is located near the bottom surface portion, of the through hole 20.
Since these films are deposited thicker closer to the hole bottom, the bottom shape of the vertical through hole 20 becomes a forward tapered shape.
In this manner, the shape of the hole bottom that most influences the step coverage of a barrier layer/seed layer 24 in subsequent steps can be tapered.
In this case, it is preferable that the total thickness of the Ti-F-C film and the Al-F-C film be 200 to 600 nm.
In addition, sediment may be linearly deposited, or may be deposited in the shape of the curve.
By tapering the bottom surface portion of the through hole 20, subsequent through-hole interconnections formation is facilitated, thereby improving the reliability.
In addition, although the angle [unit: °] of the tapered portion 22 expressed as θ in FIG. 3A is not particularly limited, it is preferable that the angle of the tapered portion 22 be in a range of 90 to 100°, for example.
In this manner, since the step coverage of a metal film 23 (barrier layer)/seed layer 24 can be further improved, through-hole interconnections formation is facilitated. As a result, the reliability of the wiring is improved.
Since the by-products that form the tapered portion 22 have more flexible mechanical properties than silicon that is a typical semiconductor material, the by-products function as a stress relaxation material between the semiconductor substrate and the through-hole interconnections.
Accordingly, it is possible to prevent a problem in that cracks are generated in the semiconductor substrate or the through-hole interconnections due to stress.
In particular, since the stress is concentrated on the corner formed by the bottom surface and the inner wall surface of the through hole 20, it is possible to prevent cracks effectively.

The tapered portion 22 formed in this manner includes the first and second metal components.
In particular, since the barrier metal film 12 is first etched at the time of etching, the second by-product including the second metal component is first generated and accordingly is first deposited on the bottom surface portion and the inner wall surface portion, which is located near the bottom surface portion, of the through hole 20.
Then, the conductive portion 13 is etched, and the first by-product including the first metal component is deposited on the second by-product.
As a result, in the tapered portion 22, the amount of the second metal component is larger than the amount of the first metal component in a portion close to the side wall of the through hole 20, and the amount of the first metal component is larger than the amount of the second metal component in a portion away from the side wall of the through hole 20.
Thus, if the first and second by-products are laminated in order, peeling occurs at the interface between a layer formed of the by-product and a layer formed of the second by-product when the stress is applied to the through hole. Due to this peeling, the effect of relaxing the stress between the through-hole interconnections and the semiconductor substrate can be expected.

In addition, these by-products (Ti-F-C and Al-F-C) contain F that reacts with moisture to generate hydrofluoric acid. In the present embodiment, however, these by-products are covered with the seed layer 24 by forming the metal film 23 (barrier layer) and the seed layer 24 continuously, as will be described later.
Accordingly, it is possible to suppress the generation of hydrofluoric acid due to the reaction of by-products and moisture.
In addition, according to the method of the present embodiment, it is possible to eliminate a step of removing by-products deposited on the bottom portion of the through hole 20 and also to form the tapered portion at the hole bottom without an additional step. As a result, it is possible to suppress an increase in the number of steps or an increase in cost.

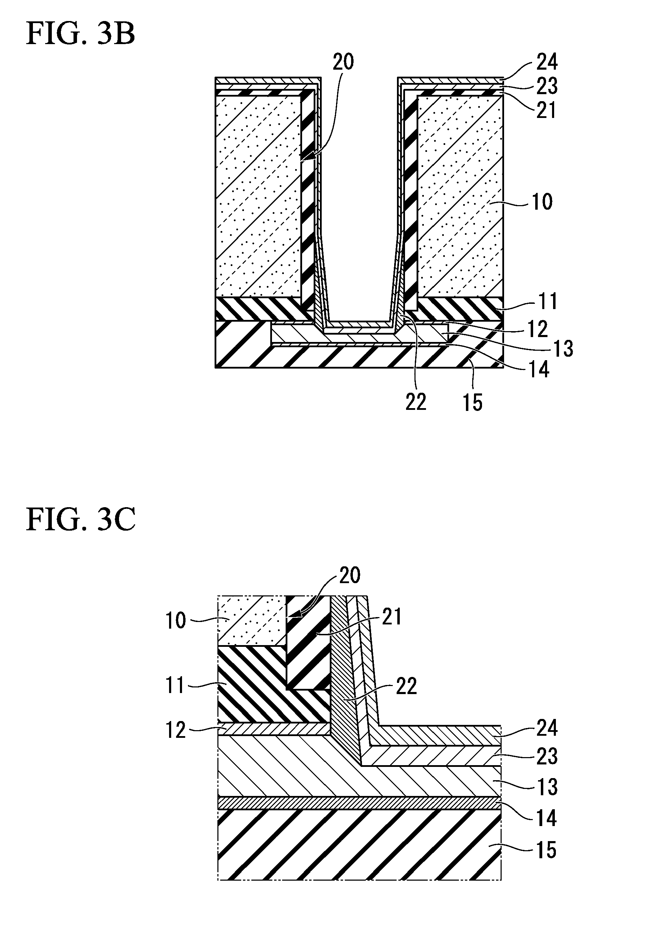

(5) The metal film 23 is formed on the inner wall surface and the bottom surface of the through hole 20 so as to cover at least the by-products (sixth step).
Then, as shown in FIGS. 3B and 3C, the metal film 23 (barrier layer) is formed in the through hole 20 using a sputtering method.
By covering the tapered portion 22 formed of by-products immediately with the metal film 23, the generation of hydrofluoric acid due to the reaction of moisture and by-products can be suppressed.
In addition, FIG. 3C is an enlarged view of main parts shown in FIG. 3B.

As examples of the material of the metal film 23, Ti, TiN, TiW, Cr, Ta, and TaN may be mentioned.
As the sputtering method, it is preferable to use a long-throw method or a collimation method in which the directivity of sputtering particles is higher than that in the typical sputtering method.

Then, the seed layer 24 (not shown) is formed in the through hole 20 using a sputtering method.
As the seed layer 24, for example, copper (Cu) is used.
Also in this case, the seed layer 24 can be formed inside the through hole 20 with good coverage by using the same sputtering method with high directivity as for the metal film 23.
Even if reverse sputtering is performed before the formation of the metal film 23, the shape of the tapered portion 22 is not changed. Accordingly, it is not necessary to perform reverse sputtering.

In this case, since the bottom surface portion of the through hole 20 is tapered due to by-products, the sputtered film is deposited with good step coverage.
In the principle of the sputtering method, metal atoms of the barrier layer/seed layer 24 are vertically incident on the hole bottom. Accordingly, if the bottom portion of the through hole 20 is inclined with respect to the vertical direction, the metal atoms easily adhere to the side wall of the through hole 20. As a result, step coverage is improved.

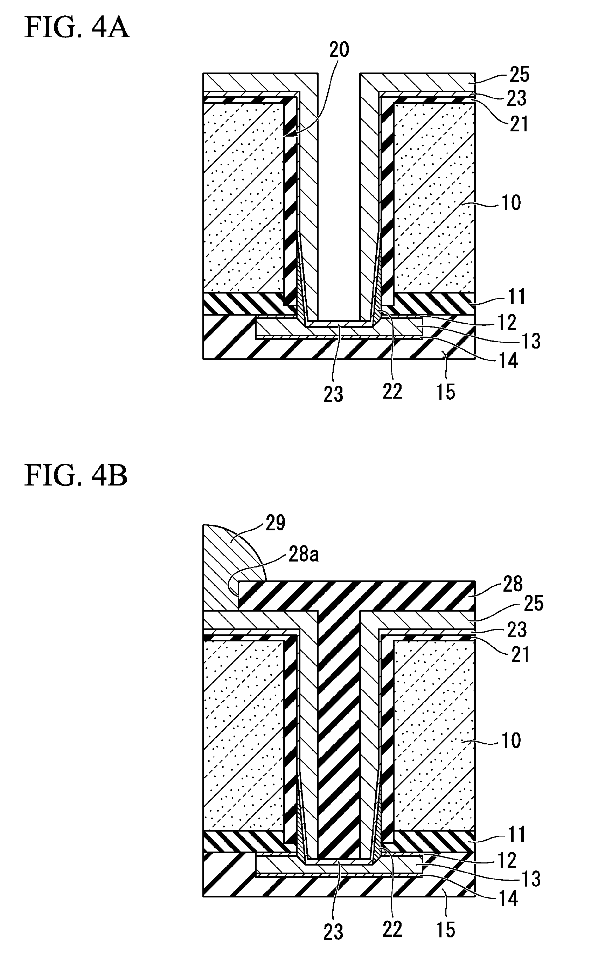

(6) The conductive layer 25 is formed on the second insulating layer 21, and the conductive layer 25 is electrically connected to the conductive portion 13 (fifth step).
Then, as shown in FIG. 4A, the conductive layer 25 as a conductor is formed in the through hole 20 using an electrolytic plating method.
As a conductor, there is no particular limitation as long as it is a good conductor. For example, not only copper, aluminum, nickel, chromium, silver, and tin with low electrical resistance but also alloys, such as Au-Sn and Sn-Pb, or solder alloys, such as Sn group, Pb group, Au group, In group, and Al group, can be utilized.

In this case, since the bottom surface portion of the through hole 20 is tapered in the present embodiment, the conductive layer 25 can be formed with good coverage.
Therefore, in the present embodiment, it is possible to manufacture the interposer substrate 1 in which there are no poor contacts and the like in the vicinity of the bottom surface portion of the through hole 20 and which has a through-hole interconnections with improved electrical stability.

(7) Then, as shown in FIG. 4B, the insulating sealing layer 28 is formed on the semiconductor substrate 10 and the conductive layer 25 (seventh step).
For example, the sealing layer 28 can be formed by patterning a photosensitive resin, such as a photosensitive polyimide-based resin, an epoxy-based resin, a silicone-based resin (silicone), and polybenzoxazole (PBO), by photolithography technique using a spin coating method or a lamination method.
In this case, an opening 28a through which at least the conductive layer 25 is exposed is provided in the sealing layer 28.
In addition, the diameter of the opening 28a can be adjusted by the opening diameter of the photomask used in the exposure.
The thickness of the sealing layer 28 is approximately 5 to 50 µm.

In addition, it is also possible to use an electrodeposition method, a spray coating method, and a printing method in order to form the sealing layer 28.
In addition, it is also possible to use a laser processing method and a plasma etching method in order to pattern the resin.
In addition, in the case of the lamination method, it is also possible to press the sheet-like resin, which is patterned in advance, by lamination.
In addition, resin may also be directly formed as a film and patterned using a screen printing method.
In addition, in these cases, resin does not need to be photosensitive.

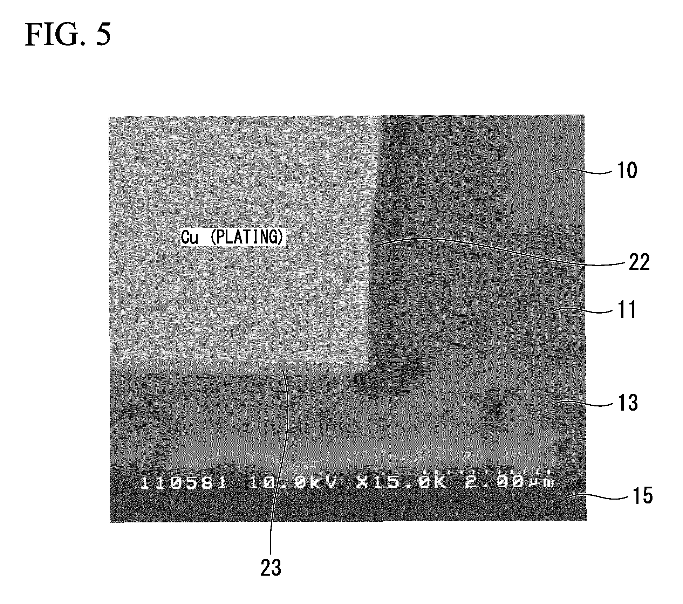

Then, solder is transferred onto the conductive layer 25 exposed at the opening 28a of the sealing layer 28 using a solder ball mounting method, an electrolytic solder plating method, a solder paste printing method, a soldering paste dispensing method, a solder vacuum deposition method, and the like.
Then, the solder balls are melted using a reflow furnace, thereby forming a solder bump 29 on a interconnection portion 23.
As described above, the interposer substrate 1 is obtained.
Here, FIG. 5 is a diagram showing an SEM photograph of the cross section of the interposer substrate manufactured by the method described above.
It is confirmed that the tapered portion 22 is formed due to the deposition of by-products on the bottom surface portion and the inner wall surface portion, which is located near the bottom surface portion, of the through hole 20.

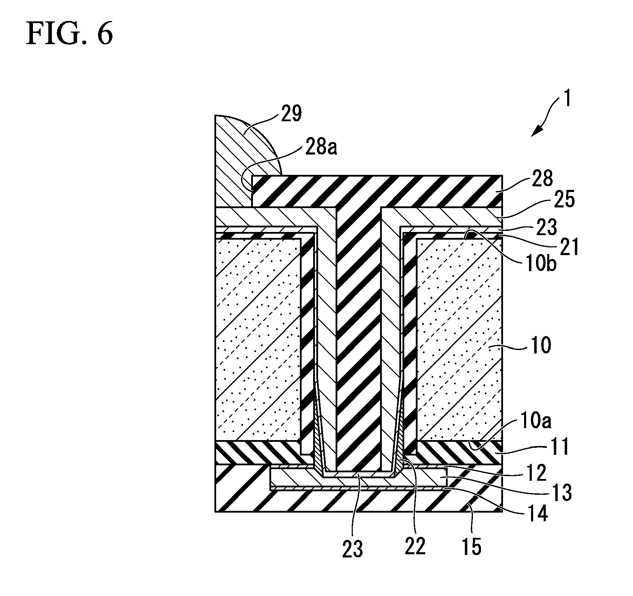

FIG. 6 is a cross-sectional view schematically showing an example of the configuration of the interposer substrate 1 of the present embodiment that is manufactured using the above-described method.
The interposer substrate 1 of the present embodiment includes the conductive portion 13 that is formed of the first metal and is disposed on one surface 10a of the semiconductor substrate 10 with the first insulating layer 11 interposed therebetween, the through hole 20 disposed such that the conductive portion 13 is exposed at the other surface side of the semiconductor substrate 10, the second insulating layer 21 disposed at least on the inner wall surface of the through hole 20, and the conductive layer 25 that is disposed on the second insulating layer 21 and is electrically connected to the conductive portion 13.
In addition, in the interposer substrate 1 of the present embodiment, the tapered portion 22 is formed over the bottom surface portion and the inner wall surface (inner side surface) portion, which is located near the bottom surface portion, of the through hole 20.
The tapered portion 22 includes the first metal component.

Since the interposer substrate 1 of the present embodiment is manufactured using the above-described method, the tapered portion 22 is formed over the bottom surface portion and the inner wall surface portion, which is located near the bottom surface portion, of the through hole 20.
The tapered portion 22 includes the first metal component.
In the present embodiment, since the bottom surface portion of the through hole 20 is tapered, the conductive layer 25 disposed on the bottom surface portion has a predetermined thickness.
Therefore, in the interposer substrate 1 of the present embodiment, there are no poor contacts and the like in the vicinity of the bottom surface portion of the through-hole interconnections. As a result, the electrical stability of the through-hole interconnections is improved.
In particular, in the interposer substrate 1 shown in FIG. 6, the barrier metal film 12 formed of the second metal is disposed between the first insulating layer 11 and the conductive portion 13, and the tapered portion 22 formed in the vicinity of the bottom surface portion of the through hole 20 includes the first and second metal components.
In particular, in the manufacturing step described above, the barrier metal film 12 is first etched at the time of etching. Therefore, the second by-product including the second metal component is first generated and accordingly is first deposited on the bottom surface portion and the inner wall surface portion, which is located near the bottom surface portion, of the through hole 20.
Then, the conductive portion 13 is etched, and the first by-product including the first metal component is deposited on the second by-product.
As a result, in the tapered portion 22, the amount of the second metal component is larger than the amount of the first metal component in a portion close to the side wall of the through hole 20, and the amount of the first metal component is larger than the amount of the second metal component in a portion away from the side wall of the through hole 20.

Although the case where the semiconductor substrate 10 is formed of Si has been described as an example in the above embodiment, the present invention is not limited to this, and may also be applied to a compound semiconductor substrate10 and an insulating substrate other than the Si substrate.
In addition, although the case where the barrier metal film 12 is formed of TiN has been described as an example in the above embodiment, the present invention is not limited to this, and the barrier metal film 12 may be formed of TiW or Cr.
In this case, by-products generated by reaction with F in etching gas at the time of etching become Ti-W-F-C and Cr-F-C.

In addition, although the case where the barrier metal film 12 formed of the second metal is disposed between the first insulating layer 11 and the conductive portion 13 has been described as an example in the above embodiment, the present invention is not limited to this, and the barrier metal film 12 may not be disposed between the first insulating layer 11 and the conductive portion 13.
In this case, the formed tapered portion 22 does not contain the second metal component.

While the interposer substrate manufacturing method and the interposer substrate of the present embodiment have been described, the present invention is not limited only to the above embodiment, and may be appropriately changed without deviating from the scope of the invention.

### INDUSTRIAL APPLICABILITY

The present invention can be widely applied to the interposer substrate manufacturing method and the interposer substrate.

### DESCRIPTION OF THE REFERENCE SYMBOLS

- 1:: interposer substrate
- 10:: semiconductor substrate
- 11:: first insulating layer
- 12:: barrier metal film
- 13:: conductive portion
- 14:: antireflection film
- 15:: third insulating layer
- 20:: through hole
- 21:: second insulating layer
- 22:: tapered portion
- 23:: metal film
- 24:: seed layer
- 25:: conductive layer

## Claims

1. A method for manufacturing an interposer substrate, the method comprising:
forming a conductive portion on a first surface of a semiconductor substrate via a first insulating layer, the conductive portion being formed of a first metal;
forming a through hole at a second surface side of the semiconductor substrate located on an opposite side to the first surface so as to expose the first insulating layer;
forming a second insulating layer on at least an inner wall surface and a bottom surface of the through hole;
exposing the conductive portion by removing portions of the first and second insulating layers using a dry etching method that uses an etching gas containing a fluorine gas, the portions of the first and second insulating layers being located on the bottom surface of the through hole; and
forming a conductive layer on the second insulating layer and electrically connecting the conductive layer to the conductive portion, wherein
when exposing the conductive portion, forming a tapered portion is performed by etching a part of the conductive portion subsequent to the second insulating layer and depositing a first by-product formed of the first metal component removed by etching and the etching gas component on a bottom surface portion of the through hole and an inner wall surface portion, the inner wall surface portion being located near the bottom surface portion.

2. The method for manufacturing an interposer substrate according to Claim 1, wherein
when forming the conductive portion, forming a barrier metal film formed of a second metal between the first insulating layer and the conductive portion is performed, and
when exposing the conductive portion, forming a tapered portion is performed by removing portions of the first and second insulating layers and the barrier metal film, the portions being located on the bottom surface of the through hole, etching a part of the conductive portion subsequent to the barrier metal film, and depositing a second by-product formed of the second metal component removed by etching and the etching gas component and the first by-product formed of the first metal component removed by etching and the etching gas component on the bottom surface portion of the through hole and the inner wall surface portion, the inner wall surface portion being located near the bottom surface portion.

3. The method for manufacturing an interposer substrate according to Claim 1 or 2,
wherein, before electrically connecting the conductive layer to the conductive portion after exposing the conductive portion, a metal film is formed so as to cover at least the by-product.

4. An interposer substrate comprising:
a conductive portion formed of a first metal and disposed on a first surface of a semiconductor substrate via a first insulating layer;
a through hole disposed at a second surface side of the semiconductor substrate so as to expose the conductive portion, the second surface side being located on an opposite side to the first surface;
a second insulating layer disposed on at least an inner wall surface of the through hole; and
a conductive layer disposed on the second insulating layer and electrically connected to the conductive portion, wherein
a tapered portion is formed over a bottom surface portion and an inner wall surface portion, the inner wall surface portion being located near the bottom surface portion, of the through hole, and
the tapered portion includes the first metal component.

5. The interposer substrate according to Claim 4, wherein
a barrier metal film formed of a second metal is disposed between the first insulating layer and the conductive portion, and
the tapered portion formed in a vicinity of the bottom surface portion of the through hole includes the first and second metal components.

6. The interposer substrate according to Claim 5, wherein
an amount of the second metal component is larger than an amount of the first metal component in a portion of the tapered portion close to a side wall of the through hole, and
the amount of the first metal component is larger than the amount of the second metal component in a portion of the tapered portion away from the side wall of the through hole.
